(19) Europäisches Patentamt
European Patent Office
Office européen des brevets

(11) EP 1 146 346 A1

(12) EUROPEAN PATENT APPLICATION

(43) Date of publication:
17.10.2001 Bulletin 2001/42

(51) Int Cl.7: G01R 33/02

(21) Application number: 01100275.5

(22) Date of filing: 03.01.2001

(84) Designated Contracting States:
AT BE CH CY DE DK ES FI FR GB GR IE IT LI LU MC NL PT SE TR
Designated Extension States:
AL LT LV MK RO SI

(30) Priority: 13.04.2000 JP 2000112643

(71) Applicants:
- Aichi Steel Corporation
Tokai-shi, Aichi-Ken 476-8666 (JP)
- Mouri, Kaneo
Nagoya-shi, Aichi-ken 468-0027 (JP)

(72) Inventors:
- Honkura, Yoshinobi, c/o Aichi steel Corp., Ltd.
Tokai-shi, aichi-ken 476-8666 (JP)
- Yamamoto,Michiharu, c/o Aichi steel Corp., Ltd.
Tokai-shi, aichi-ken 476-8666 (JP)
- Mouri, Kaneo
Nagoya-shi, Aichi-ken 468-0027 (JP)

(74) Representative:
Leson, Thomas Johannes Alois, Dipl.-Ing.
Tiedtke-Bühling-Kinne & Partner GbR,
TBK-Patent,
Bavariaring 4
80336 München (DE)

(54) **Magnetic field detection device**

(57) A magnetic field detection device that detects two components of an external magnetic field. The device uses the magneto-impedance effect in ferromagnetic amorphous wire (10). A detection coil (11) wrapped around the amorphous wire detects the magnetic flux change of the amorphous wire, which is proportional to the external magnetic field. The sensitivity of the device is increased due to circuitry (15,16) that extracts the initial output pulse. It is also increased with the use of negative feedback (17,12) and with the comparison of differential outputs. The two sets of detection elements are placed orthogonally for greatest sensitivity. Resin molding is employed for easy handling. This detection device can be used as part of a compass.

FIG. 4

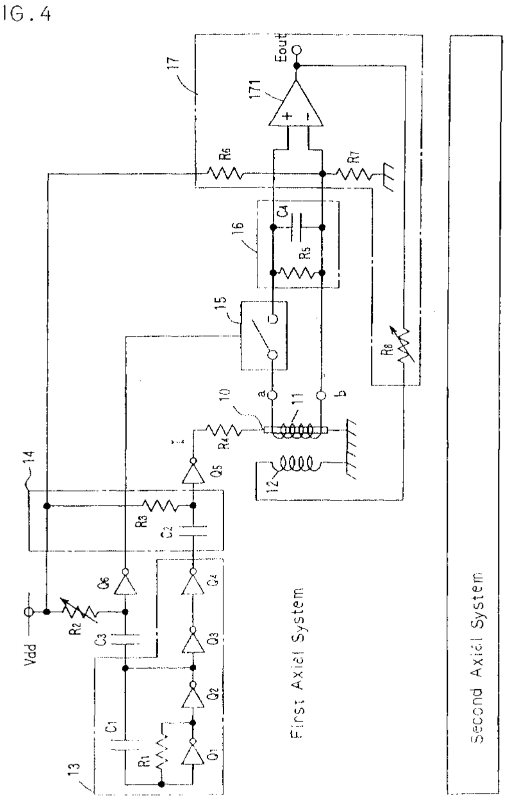




Printed by Jouve, 75001 PARIS (FR)

## Description

The present invention relates to a supersensitive magnetic field detection device. In general, the present invention is a device that can detect two components of any magnetic field vector. Specifically with respect to the detection of terrestrial magnetism, the present invention can be employed as part of a compass. As a concrete example of a practical application, it can be employed as part of a device which detects the position or direction of movement of an automobile.

As described in a previous patent, the inventor discovered the phenomenon where, when a high frequency (HF) electric current greater than 200 KHz is run (passed) through an ferromagnetic amorphous metal wire on the order of 50 μm in diameter, there is a large change in the impedance of the above-mentioned wire in response to the external magnetic field component parallel to the wire. The phenomenon is called the magneto-impedance effect. Using this principle, a miniature detection element to detect the intensity of the external magnetic field with high sensitivity is proposed (Japanese Patent Application Laid-Open (kokai) No. 7-81239).

It is also found that the above impedance change is dependant on the absolute intensity of the external magnetic field in the range of 0-400 A/m and hence the impedance change alone cannot be used to determine the polarity of the external field. In order to detect the polarity of the field, a direction sensor was invented by applying a DC bias magnetic field to the element to yield a certain offset at a zero external field (Japanese Patent Application Laid-Open (kokai) No. 7-248365). These magnetic field sensors utilizing the magneto-impedance effect are called magneto-impedance sensors.

The primary purpose of the present invention is to offer a device to measure two different components of a magnetic field vector on the basis of the magneto-impedance effect.
The second purpose of this invention is to give a very high sensitivity to the above-mentioned device.

The third purpose of this invention is to improve precision of the detection of the two components of the magnetic field vector.

The fourth purpose of this invention is to reduce the energy consumption of the detection of the two components of the magnetic field vector.

The fifth purpose of this invention is to miniaturize the detection device to used to detect the two components of the magnetic field vector.

Although it is our intention for this patent application to individually achieve the above-mentioned various purposes, the successful presentation of the invention should not be understood to mean the accomplishment of all of the various purposes.

The first major aspect of the magnetic field detection device of the present invention is that it comprises a magneto-sensitive element, hereafter called the first magneto-sensitive element, which is magnetically excited in its circuital direction by either a pulsed current or a HF current to detect an axial component of the external magnetic field, hereafter called the first axial component. Additionally, in order to detect at least one other axial component, the device of the present invention also comprises a second magneto-sensitive element, hereafter called the second magneto-sensitive element, arranged on a plane that possesses a common normal to the plane containing the first magneto-sensitive element, which is magnetically excited in its circuital direction by either a pulsed current or a HF current to detect an axial component of the external magnetic field, hereafter called the second axial component.

A coil, hereafter called the first detection coil, is wrapped around the first magneto-sensitive element and used to detect the magnetic flux fluctuation in the first axial direction. Another coil, hereafter called the second detection coil, is wrapped around the second magneto-sensitive element and can detect the magnetic flux fluctuation in the second axial direction.

This magnetic field detection device is constructed to detect two different components of a magnetic field vector. If the first and second magneto-sensitive elements are, for example, wire-shaped elements, they will be excited in the circuital direction when a pulsed current is passed through them. With this excitation in the circuital direction, the internal magnetic moment will change in response to the pulsed electric current. When the first axial component is at a right angle to the circuital direction of the first magneto-sensitive element, i.e., in the axial direction in the case of a wire-shaped element, and the exciting magnetic field is large in the circuital direction, the magnetic moment of the magneto-sensitive element becomes oriented towards the circuital direction. However, when the exciting magnetic field is small, the magnetic moment tends to be oriented towards the first axial direction. That is to say that the magnetic moment changes in the first axial direction in response to a pulsed current or a HF current. With this change, a corresponding change occurs in the magnetic flux in the first axial direction and the first detection coil detects this flux change. The change in the magnetic flux is proportional to the intensity of the first axial component of the external magnetic field. The second magneto-sensitive element works in a similar fashion as the first magneto-sensitive element. In this way, with the analysis of the first and second detection coils, it is possible to detect both the first and second axial directions of the external magnetic field.

The rate of change of the output related to the external magnetic field, that is to say the sensitivity, is proportional to the strength and the frequency of the magnetic excitation in the circuital direction. In the present invention, a pulsed current or a HF current is applied, thus the maximum frequency of magnetic excitation is very high, and the sensitivity is improved accordingly.

The present invention has been able to be miniaturized because there is no need for bias coils to supply a zero-offset bias magnetic field. Without the above-mentioned coils there is no need to provide space for their dissipation of heat and interference with each other, and in turn the need to distance the magneto-sensitive elements from each other is reduced.

In addition, as the detection coils are used to detect the change in the magnetic flux in the magneto-sensitive elements induced by the external magnetic field, it was possible to improve the sensitivity by increasing the number of turns of the detection coils.

With the first and second magneto-sensitive elements arranged in different directions, the magnetic field components in these directions can be detected. It is desired that the magneto-sensitive element possess magnetic anisotropy in the circuital direction so that it can be easily magnetized in that direction. With this anisotropy, the magnetic flux change in the element is effectively induced by the external magnetic field, thus it is possible to improve the detection sensitivity. One type of this material is ferromagnetic amorphous metal. It is desired that the material have a wire shape.

The first and second magneto-sensitive elements are arranged in two different directions, and it is most desirable if they are arranged at right angles to each other. When at right angles, the most sensitive detection of the first and second axial components is possible. From these detected components, the measurement of the magnetic field strength and/or the field direction is possible. It is not necessary that the first and second magneto-sensitive elements be arranged on the same plane. For example, it is acceptable for one to be set on a level surface and for the other to be set on the back of that level surface. With this arrangement, the device size can be miniaturized.A pulsed current can be considered to be a type of HF current. Either a single cycle or a repetition of a cycle of a pulsed current is acceptable as the applied electric current.

A second aspect of the present invention, as stated in claim 2, is that the magnetic field detection device has a switch, hereafter called the first switch, which can extract the initial pulse of the first detection coil output. The present invention also has another switch, hereafter called the second switch, which can extract the initial pulse of the second detection coil output. When a pulsed current is applied to the magneto-sensitive element, the voltage between the terminals of the detection coil also takes on a pulsed waveform. It is possible to detect the external magnetic field by detecting this waveform's greatest value. However, as there exists an inductance component or floating capacity in the coil, the detection voltage oscillates after its first pulse. Therefore, it is desired to sample only the first pulse from the detection signal to measure the external magnetic field.

By using the first and second switches, it is possible to reduce the noise effect caused by the above-mentioned inductance component or floating capacity of the detection coil and obtain high accuracy detection of the external magnetic field.

A third aspect of the present invention, as stated in claim 3, is that the magnetic field detection device has a signal processing circuit, hereafter called the first signal processing circuit, which outputs a signal formed either by the peak of the single or repeated signal passed through the first switch. The present invention also has another signal processing circuit, hereafter called the second signal processing circuit, which outputs the signal formed either by the peak of the signal passed through the second switch or by the repeated output signal.

The peak value of the signal passed through the first switch is proportional to the first axial component of the external magnetic field. Therefore, the signal created from the repeated output of this peak value (an envelope curve signal, an integral signal, a signal passed through a low pass filter, a smoothed signal, etc.), for example when the peak value is held or repeated, can be used for the detection of the first axial component. Either a static or an alternating external magnetic field can be measured. When measuring an alternating field, its frequency must be sufficiently lower than that of the pulsed current frequency.

A fourth aspect of the present invention, as stated in claim 4, is that the magnetic field detection device has a negative feedback coil, hereafter called the first negative feedback coil, wrapped around the first magneto-sensitive element which can generate a magnetic field which cancels the first axial component of the external magnetic field in response to the output signal of the first signal processing circuit. The field detection device also has another negative feedback coil, hereafter called the second negative feedback coil, wrapped around the second magneto-sensitive element which can generate a magnetic field which cancels the second axial component of the external magnetic field in response to the output signal of the second signal processing circuit. The field detection device also possesses a negative feedback circuit, hereafter called the first negative feedback circuit, which controls the flow of electricity to the first negative feedback coil in order to make the output signal of the first signal processing circuit equal to zero, and likewise possesses another negative feedback circuit, called the second negative feedback circuit, which acts similarly.

In the present invention as described above, the negative feedback current, which is passed through the negative feedback coil to cancel out the external magnetic field component in the respective direction, is proportional to the external magnetic field itself. This means that the negative feedback current can be used to measure the external magnetic field.

The advantage of using the negative feedback current as the index of the external magnetic field, and not the detection coil output itself, is that the zero point of the magneto-sensitive element is used for the detection of a magnetic field of any intensity. The greatest linearity is observed between the external field and its detection coil output at this zero point, so using this zero point allows for increased measurement precision. This same relation is true for the both the first and second axial components detected via the first and second magneto-sensitive elements.

A fifth aspect of the present invention, as mentioned in claim 5 and 6, is that the magnetic field detection device comprises a pulse generator to supply the pulsed current to the magneto-sensitive elements. It can therefore supply a pulsed current to the first and second magneto-detection elements at the highest possible frequency thus improving the detection sensitivity.

There can be a single current-supplying pulse generator that supplies the pulsed current to the first and second magneto-sensitive elements, or two separate current-supplying pulse generators can supply the elements. It is advantageous to make the pulse generator common for the first and second magneto-sensitive elements to reduce the size of the device.

A sixth aspect of the present invention, as mentioned in claim 7, is that the pulse generator comprises a square wave generating circuit and a differentiation circuit. The differentiation circuit differentiates the output of the square wave generating circuit, expressing the differential signal as a pulsed current. With this structure, it is possible to realize both high sensitivity and low energy consumption.

Although the previously described device has included only a single magneto-sensitive element to detect one component of the external magnetic field, it is possible to have a pair of magneto-sensitive elements to detect one direction. In that case, there is also a pair of detection coils and other components. Using a pair of components detecting the same component of the external magnetic field, and taking the difference between them, the performance of the detection device can be improved.

A seventh aspect of the present invention, as mentioned in claim 8, is that the magnetic field detection device of claim 1 comprises a pair of first magneto-sensitive elements both penetrated by the first axial component of the external magnetic field, through which a pulsed current is passed. Around each of these first magneto-sensitive elements one of a pair of first detection coils is wound. The magnetic field detection device also comprises a pair of second magneto-sensitive elements both penetrated by the second axial component of the external magnetic field, through which a pulsed current is passed. Around each of these second magneto-sensitive elements one of a pair of second detection coils is wound.

The above-mentioned invention is characterized by having a pair of each component named in claim 1, namely the first and second magneto-sensitive elements and the first and second detection coils. The pairing of these components makes it possible to eliminate the in-phase disturbances that are commonly superposed. These disturbances include the DC component of the external filed, the in-phase noise, and output drift caused mainly by temperature fluctuations. With paired measurement components, it is possible to cancel the in-phase disturbances thus improving the detection precision.

The polarity of the two detection coils in one system in relation to the external magnetic flux is determined in order to produce opposite-phase output detection signals. In this way, by taking the difference between the two detection signals, the signal is increased twofold, while the in-phase noise and other in-phase components are eliminated.

An eighth aspect of the present invention, as mentioned in claim 9, is that the present invention possesses two pairs of switches. The initial pulse of the respective outputs of the pair of first detection coils is passed through the respective switch of the pair of first switches. The second pair of switches and outputs of the second detection coils has a similar relation.

With the elimination of the in-phase external disturbances, the effective application of the present invention as outlined in claim 8 can be accomplished. This makes it possible to realize the improvement of the detection sensitivity and precision.

A ninth aspect of the present invention, as mentioned in claim 10, is that it comprises two pairs of signal processing circuits. The pair of first signal processing circuits output signals formed either by the peak of the single or repeated signals passed through the pair of first switches. Similarly, the pair of second signal processing circuits output signals formed either by the peak of the single or repeated signals passed through the pair of second switches. With the elimination of the in-phase external disturbances, the effective application of the present invention as outlined in claim 9 can be accomplished. This makes it possible to realize the improvement of the detection sensitivity and precision

A tenth aspect of the present invention, as described in claim 11, is that it comprises a pair of first negative feedback coils that generate a magnetic field in the opposite direction as the first axial component that cancels the first axial component of the external magnetic field in response to the output signals of the pair of fist signal processing circuits. It also comprises a pair of second negative feedback coils that generate a similar magnetic field to cancel the second axial component of the external magnetic field.

The present invention also comprises a first negative feedback circuit that supplies a current to the pair of first negative feedback coils, which makes the difference between the opposite-polarity outputs of the pair of signal processing circuits equal to zero. The present invention also comprises a similarly acting second negative feedback circuit.

The external magnetic field is proportional to the sum of the two outputs of the pair of first signal processing circuits, that is to say, it is proportional to the difference between the opposite-polarity outputs of the first signal processing circuits. Therefore, in order to cancel the external magnetic field by making this sum equal to zero, electric current is supplied to the pair of first negative feedback coils. The relation for the second negative feedback coils is similar.

According to the above discussion, the in-phase component of the detection signal (in-phase noise, drift, DC component, etc.) is eliminated because the difference is taken. With this construction allowing for the elimination of in-phase external disturbances, the effective application of the present invention. as described in claim 10, can be accomplished. Consequently, there is good linearity between the output values and the detected magnetic field values. Additionally, precise detection is possible after the removal of the external disturbances.

An eleventh aspect of the present invention, as mentioned in claim 12 and 13, and as is true for any invention mentioned in claim 8 or 11, is that the oscillator which provides a pulsed current to the pair of first magneto-sensitive elements and the oscillator which provides a pulsed current to the pair of second magneto-sensitive elements can be either independent or common.

If a single oscillator is used, a drop in production costs and the miniaturization of the device can be realized.

A twelfth aspect of the present invention, as mentioned in claim 14, is that the present invention has an oscillator which comprises a square wave oscillating circuit and a differentiating circuit. The differentiating circuit creates a pulsed current from the differentiated output of the square wave oscillating circuit.

By taking advantage of this setup, the sensitivity can be increased and the energy consumption can be decreased.

A thirteenth aspect of the present invention, as mentioned in claim 15 and 16, and is true for any invention mentioned in claim 1 or 7, is that one end of the first and the second magneto sensitive elements, as well as one end of the negative feedback coil, is connected to ground.

This reduction of the number of external terminals makes the connection of the device to external circuits easier and simpler.

A fourteenth aspect of the present invention, as mentioned in claim 17 and 18, and is true for any invention mentioned in claim 8 or 14, is that the connection point of the pair of first magneto-sensitive elements, the connection point of the pair of second magneto-sensitive elements, as well as one end of the series connection of the negative feedback coils are connected to ground.

This reduction of the number of external terminals makes the connection of the device to external circuits easier and simpler.

A fifteenth aspect of the present invention, as mentioned in claim 19 - 21, and is true for any invention mentioned in claim 1 ,8 or 11, is that the first magneto-sensitive elements, as well as the second magneto-sensitive elements, possess magnetic anisotropy in the circuital direction.

With this magnetic anisotropy in the circuital direction, it is possible to increase the detection sensitivity of the external magnetic field.

A sixteenth aspect of the present invention, as mentioned in claim 22, is that the first and second magneto-sensitive elements are elements that have a skin effect with respect to the pulsed current.

Generation of a skin effect results in the restriction of the electric current to the surface. This increases the magnetic modulation for a given magnetic field and a given pulsed current, thus increasing the detection sensitivity.

A seventeenth aspect of the present invention, as mentioned in claim 23 and 24, and is true for any invention mentioned in claim 19 or 21, is that the first and second magneto-sensitive elements are made of ferromagnetic amorphous metal. By adopting a composition of ferromagnetic amorphous metal, it is possible to have a magnetic anisotropy where the magnetic permeability in the circuital direction is larger than that in the axial direction.

An eighteenth aspect of the present invention, as mentioned in claim 25 and 26, and is true for all inventions in claim 19 or 21, is that the first and second magneto-sensitive elements are ferromagnetic amorphous metal wire. By adopting a wire shape, it is possible to have a magnetic anisotropy where the magnetic permeability in the circuital direction is larger than that in the axial direction.

A nineteenth aspect of the present invention, as mentioned in claim 27 and 28, and is true for all inventions in claim 1 or 26, is that the first and second magneto-sensitive elements, the first and second detection coils and the first and second negative feedback coils are loaded on a base and united into a resin-mold package.

With this structure, the sensor can be treated as an independent sensor chip, thus the arrangement on the circuit board is easy. Moreover, in the case of malfunction, only the sensor chip need be exchanged, thus making the maintenance of the device with this sensor chip easy.

A twentieth aspect of the present invention, as mentioned in claim 29 - 32, and is true for all inventions in claim 1, 4, 8, or 11, is that both ends of the first and second magneto-sensitive elements are supported by the electrode formed on the base. The gel-like substance surrounds the first and second magneto-sensitive elements and fills in the space between them.

By using the gel-like substance, the first and second magneto-sensitive elements are protected from excess external stresses. Especially in the case of a ferromagnetic amorphous magnetic element, deformation of the element results in decreased detection precision. During resin molding, the stress that is generated during the cooling process of the resin is usually incurred by the magneto-sensitive elements. However, using the gel-like substance prevents this stress from affecting the magneto-sensitive elements, as the gel-like substance absorbs the deformation. The gel-like substance is a colloidal solution hardened into a jelly. For example, silicone gel, silica gel, elastomer, gelatin, or in general, hydro gel or other elastic gel may be applied as the gel-like substance. The essential part is having an elastic substance that can absorb stress.

A twenty-first aspect of the present invention, as mentioned in claim 33 and 34, and is true for all inventions in claim 1 or 8, is that the first magneto-sensitive element is arranged on the surface of the base, and the second magneto-sensitive element is arranged on the back of the base.

When the first and second magneto-sensitive elements are arranged on the surface of the base in this way, it is possible to miniaturize the device. Moreover, as the first and second magneto-sensitive elements can cross, and the detection locations of the first and second axial components of the external magnetic field approach each other, the precise measurement of the two components of the external magnetic field is possible.

A twenty-second aspect of the present invention, as mentioned in claim 35 - 38, and is true for all inventions in claim 1, 4, 8, or 11, is that the both ends of the first and second magneto-sensitive elements are supported and electrically connected on the electrodes, and the elements are covered in aluminum or aluminum alloy, then the first magneto-sensitive elements, as well as the second magneto-sensitive elements, and the electrodes are connected by way of ultrasonic bonding. In the case that the magneto-sensitive element is made of ferromagnetic amorphous metal, excess heat induces crystallization from the amorphous state of the metal that results in a deterioration of the sensitivity. The material is also quite susceptible to mechanical deformation. Therefore, ultrasonic bonding, which generates almost no heat during bonding, is preferred. In the case of ultrasonic bonding, the aluminum or aluminum alloy is placed over the magneto-sensitive elements and acts as a shock absorber for the pressure of the ultrasonic tool, thus preventing the deformation of the magneto-sensitive elements. Moreover, the oxide formed on the surface of the magneto-sensitive element is exfoliated and chemically combined with the aluminum or aluminum alloy. As a result of this, the mechanical or electrical connection of the aluminum or aluminum alloy and the magneto-sensitive elements is carried our successfully.

A twenty-third aspect of the present invention, as mentioned in claim 39 and 40, is that the electrodes are formed of nickel, aluminum, gold, copper, silver, tin, zinc, platinum, magnesium, rhodium, or an alloy containing at least one of these elements.

With electrodes made of these materials, a secure connection with the magneto-sensitive element is possible.

A twenty-fourth aspect of the present invention, as mentioned in claim 41 and 42, is that the electrodes possess a surface layer of aluminum or aluminum alloy.

With this construction, there is a good connection between the magneto-sensitive element and the aluminum or aluminum alloy laid over it, and the secure connection between the magneto-sensitive element and the electrode is possible.

A twenty-fifth aspect of the present invention, as mentioned in claim 43 and 44, and is true for all inventions in claim 1 or 42, is that the magnetic field detection device is a compass that can detect the direction of the external magnetic field, i.e., it can detect the first and second axial external magnetic field components. From the detection of the first and second axial magnetic field components, the direction detection is possible. That is to say that if the first and second axes are chosen in the horizontal plane, it is possible to detect the direction in the horizontal plane.

A twenty-sixth aspect of the present invention, as mentioned in claim 45, and is true for the invention in claim 43, is that the first and second axes cross each other.

With this construction, having the directions of the first and second axial magnetic field components 90 degrees from each other yields the largest values, and thus increases the direction detection precision.

FIG. 1 is a principle of the present invention.

FIG. 2 is a principle of terrestrial direction detection for the present invention.

FIG. 3 is an illustration of characteristics of the relationship between the detected external magnetic field and the detection signal for the present invention.

FIG 4 is an illustration of the circuitry of the enforceable magnetic field detection device of the present invention.

FIG 5 is an illustration of the circuitry of another enforceable magnetic field detection device of the present invention.

FIGS 6A and 6B are illustrations of the construction of the single element loaded with a magneto-sensitive element.

FIG 7 is an illustration of a cross section of the connection between a magneto-sensitive element and an electrode.

FIG 8 is an illustration of a plan view of the assembled detection device.

FIG 9 is an illustration of a lateral view of the assembled detection device.

FIG 10 is an illustration of a perspective view of the assembled detection device.

The embodiment of the present invention is explained as follows.
This is an explanation of the fundamental principles of the magnetic field detection of the present invention. Figure 1 shows these principles. The electric current I is run through the wire-shaped first magneto-sensitive element 10 in the first axial (x axis) direction. By doing so, the magnetic field $H_r$ is generated in the circuital direction, that is in the direction perpendicular to the current. The magnetic moment M of the first magneto-sensitive element 10 is also arranged in the circuital direction by the magnetic field $H_r$. If the current I is an alternating current with frequency $\omega$, the magnetic field $H_r$ oscillates at the frequency$\omega$, and the magnetic moment M also oscillates at the frequency$\omega$. Under the conditions where this AC current I is run, a static or alternating external magnetic field $H_x$, which has a sufficiently low frequency, is applied. With this, the magnetic vector M slants in the direction of the external magnetic field $H_x$. Thus the magnetic vector M possesses an alternating component in the first axial direction. In this way, the magnetic vector M oscillates simultaneously with the AC current in the first axial direction. As a result, the component of the flux density in the first axial direction $B_x$ fluctuates with time. The amplitude of this magnetic flux density $B_x$ is proportional to the size of the external magnetic field $H_x$. The rate of change with time of this magnetic flux density $B_x$ is proportional to the product of the frequency $\omega$ and the amplitude of the magnetic flux density $B_x$. The voltage $E_1$ between the terminals of the first detection coil 11 is detected. Consequently, the voltage between these terminals $E_1$ can determine the external magnetic field in the first axial direction $H_x$.

Because the voltage between the terminals is proportional to the product of the frequency $\omega$ of the current I and the external magnetic field $H_x$, when the frequency $\omega$ is high, the detection sensitivity becomes greater. In the present invention, it is desired that the supplied current I be a pulsed current. Of course, an AC current or pulsed current is also acceptable. When the frequency $\omega$is high, the current only flows on the surface of the magneto-sensitive element due to the skin effect. This effect suppresses the movement of the magnetic domain wall inside the material. In this state, only the external magnetic field contributes to the magneto-impedance effect and thus the sensitivity of the element is maximized. Therefore, it is desired to use a pulsed current that possesses a high-frequency component. It is acceptable to apply the current for only a single cycle, or to apply the current in repeated cycles.

If the pulsed current is applied to the magneto-sensitive element in this way, the voltage $E_1$ between the terminals of the detection coil also take on a pulsed waveform. It is possible to detect the external magnetic field by detecting this waveform's greatest value. Actually, because there exists an inductance component or floating capacity of the first detection coil, the detection signal oscillates as a pulsed current. Therefore, it is desired to measure the magnetic field from the amplitude by sampling only the first pulse from the detection signal.

As mentioned above, the present invention makes use of the so-called magneto-impedance effect. This effect is seen when a high frequency electric current is passed through a ferromagnetic amorphous metal wire and a large change in the impedance of the wire is seen in response to the external magnetic field component parallel to the wire.

When there exists a magnetic field component in the first axial direction, and the magneto-sensitive element is excited with an AC current, an alternating flux density with the same frequency and an amplitude proportional to the magnetic field is generated in the first axial direction for the present invention.

It is especially desired in the present invention that the first magneto-sensitive element be ferromagnetic amorphous metal wire stretched in the first axial direction. Ferromagnetic amorphous metals such as CoSiB, FeCoSiB, FeSiB, or other alloys of the previous can be used.

As shown in Figure 2, the second magneto-sensitive element is arranged in the second axial direction (y direction), i.e., is arranged in a different direction than the first axial direction of the first magneto-sensitive element 10 and the first detection coil 11, but has the same construction as the first magneto-sensitive element. When the same pulsed current I is supplied to the second magneto-sensitive element 40, the component of the magnetic field in the second axial direction $H_y$ can be measured by measuring the voltage $E_2$ between the terminals of the second detection coil 41. The angle formed between these two axis is defined as $\alpha$ and the angle between the external magnetic field and the first axis is defined as $\theta$.

$$\theta = \tan^{-1} [ ( E_2/E_1 -\cos\alpha) /\sin\alpha] \qquad (1)$$

Furthermore, the strength of the external magnetic field can be determined by applying the next equation.

$$H=H_1/\cos\theta \qquad (2)$$

When the angle $\alpha$ the first and second axes is 90 degrees,

$$\theta= \tan^{-1} (E_2/ E_1) \qquad (3)$$

$$H=( E_1^2 +E_2^2 )^{1/2} \qquad (4)$$

When the pulsed current 1 is run, the amplitude $E_0$ of the first pulse of the output signal $E_1$ of the first detection coil 11 can be used to measure the first axial component of the external magnetic field, as seen in Figure 3.

A concrete outline of the circuit structure for the detection of the first axial component of the magnetic field is shown in Figure 4.

The first detection coil 11 is wrapped perpendicularly around the first magneto-sensitive element 10. The first magneto-sensitive element is constructed of, for example, a wire-shaped non-magnetostrictive ferromagnetic amorphous metal element. A concrete example of the dimensions are length of 3 mm and diameter of 30 µm. Furthermore, one example of the number of turns of the first detection coil is 40 turns. The oscillator 13 produces square waves. One concrete example of an oscillator that may be used is a C-MOS multi vibrator. This square wave is differentiated by the differential circuit 14 and applied to the first magneto-sensitive element through resistor $R_4$. The purpose of resistor $R_4$ is to supply a constant current. From this type of circuit, the pulsed current I is supplied to the first magneto-sensitive element 10. The rise time of the pulsed current is about 5 ns.

The first switch 15 is connected to the end a of the first detection coil 11. One concrete example of a possible first switch 15 is an analog switch comprising a transistor. The signal passed through the first switch 15 is then input to the first signal processing circuit 16. One example of the first signal processing circuit 16 is the peak-hold circuit made from the capacitor $C_4$ and the resistor $R_5$. This first signal processing circuit holds the peak of the detected repeated pulsed signal. In the case that a pulsed current is repeatedly supplied and a pulsed signal is repeatedly detected, it is possible to apply an integral circuit or a smoothing circuit in place of this peak-hold circuit.

The first detection coil 11 possesses inductance and floating capacity, as do other circuit components. Hence, the detection signal of the first detection coil 11 is not a single pulse responding to the pulsed current, but includes a continuing oscillating wave. The first switch 15 is provided in order to abstract only the component responding to the pulsed current. In order to match the phases of the output of the first detection coil 11 and the time when the first switch 15 is completely on, the control signal of the first switch 15 is delayed about 10 ns from time when the pulsed current I supplied to the first magneto-sensitive element 10. In fact, the first switch 15 responds to the pulsed current and the control signal is such that the switch is on only during the period precisely when only the signal component proportional to the external magnetic field is being passed.

The output of the first signal processing circuit 16 is input to the first negative feedback circuit 17. The other end b of the first detection coil 11 is connected to the inverting input terminal of the differential amplifier 171, while the signal voltage of the first signal processing circuit 16 is connected to the non-inverting input terminal of the differential amplifier 171. Therefore, the output terminals of the differential amplifier 171 are connected to the first negative feedback coil 12. With this structure, when the voltage between the two input terminals of the differential amplifier 171 is equal to zero, current flows through the first negative feedback coil 12. That is to say, when the external magnetic field in the direction of the first magneto-sensitive element 10 is equal to zero, the first negative feedback coil ultimately has a negation action on the external field to be detected because the detection signal of the first detection coil 11 becomes zero. When there is no negative feedback, if the detection signal of point A, as seen in Figure 3, is output, the current necessary for the to shift point A to the origin is supplied to the first negative feedback coil 12. As this negative feedback current is proportional to the external magnetic field of point A, the output signal is proportional to the strength of the magnetic field of point A. In this way, magnetic field measurement with good linearity is possible if the measurement point is in the vicinity of the origin of the characteristic curve of Figure 3.

This type of circuit is similarly prepared for the detection of the second axial magnetic field component. The circuit construction is completely the same. It is acceptable for the oscillator, made of the square wave oscillator circuit 13 and the differential circuit 14, to be either common or independent. In the case where the same pulsed current is supplied to both the first and second magneto-sensitive elements, it is acceptable use the same circuit to supply the control signal for the first and second switches.

Next will follow an explanation of the detection device comprising a pair of first magneto-sensitive elements, first signal processing circuits, first negative feedback circuits, first negative feedback coils, etc. These paired components eliminate in-phase noise and improve the detection precision.

In the direction of the first axial magnetic field component, there is a pair of first magneto-sensitive elements 10a and 10b, which have a parallel electrical arrangement. As described later, the mechanical arrangement can be either parallel or series. As it is desired that the same first axial component goes through the axes of 10a and 10b, it is best if their locations are close and parallel to each other.

As shown in Figure 5, the connection point d of the pair of first magneto-sensitive elements 10a and 10b is connected to ground. The pulsed current is supplied from the respective opposite ends e and f. The pair of first negative feedback coils 12a and 12b are arranged in series and the same negative feedback current is run through them, thus they function to make the internal magnetic field of the pair of first magneto-sensitive elements 10a and 10b equal to zero. In other words, the respective first negative feedback coils 12a and 12b are wound in the direction negating the external magnetic field. The pair of detection coils 11a and 11b are wound around the respective first magneto-sensitive elements 10a and 10b. In order for the signals passed through the pair of first switches 15a and 15b to have opposite polarities, the respective switches are connected to opposite terminals of either of the detection coils 11a and 11b. The circuit is arranged so that the directions of the electromotive forces $E_{a1}$ and $E_{b1}$ of the respective first detection coils 11a and 11b are the directions as shown in Figure 5. The output signal Ga1 of the first signal processing circuit 16a is input to the inverting input terminal of the differential amplifier 171, while the output signal Gb1 of the first signal processing circuit 16b is input to the non-inverting terminal of the differential amplifier 171. Thus, in order to set the relation $Gb_1 - Ga_1 = Eb_1 - (-Ea_1) = Eb_1 + Ea_1$ equal to zero, a negative feedback current is supplied to the pair of first feedback coils 12a and 12b. Furthermore, in order to set the electromotive forces $E_{a1}$ and $E_{b1}$ of the first detection coils 11a and 11b equal to zero, a negative feedback current is supplied to the first negative feedback coils 12a and 12b. Thus, as stated before, measurement with good linearity and high detection precision is possible when the magnetic field is measured in the vicinity of the origin of the characteristic curve of Figure 3.

The external magnetic field is detected with good precision and linearity, as the in-phase components included in both of the two output signals of the differential amplifier 171 are canceled. As a result, the in-phase components included in the detection signal have no influence on the negative feedback current. The in-phase component includes noise and signal drift caused by temperature fluctuation and the like. Consequently, the precision of detection is improved with the elimination of these in-phase external disturbances.

For the detection of the second axial magnetic field component, the construction is exactly the same as that for the detection of the first axial magnetic field component. The oscillator 18 can be common for the pair of first detection coils 10a and 10b, as shown in Figure 5, or two independent oscillators can be used for each coil. It is also possible to use a single oscillator for two detection systems, or conversely to use two oscillator for each system.

Next, the mechanical construction of the magnetic field detection device will be explained. As shown in Figure 6, the first magneto-sensitive element 10a is arranged on top of the base 30a. On top of the base 30a, the electrodes 31a and 32a are arranged. On top of these electrodes, the ends of the first magneto-sensitive element 10a are arranged so as to support the flow of electricity. The first magneto-sensitive element 10a is joined to the electrodes 31a and 32a by ultrasonic bonding employing aluminum plates 33a and 34a.

Below will follow a detailed explanation of the formation method of the sensor chip 100 as shown in Figure 6. First, copper is vaporized onto the surface of the flat base made of ceramics, PCB resin, silicon, or other material. It is desired that the base be non-conductive. At least, it is necessary that the portion where the electrodes are formed be non-conductive. Then, after the photolithography process, etching is carried out so as to leave the electrodes 31a and 32a. In this way, it is possible to arrange a great number of magneto-sensitive elements 10a on the base. Next, the magneto-sensitive element 10a is arranged on the electrodes 31a and 32a on the base and then, as shown in Figure 7, a plate made of aluminum or aluminum alloy 33a is arranged on top. A bonding tool 90 is used to apply pressure to the top of the plate 33a, ultrasonic vibration occurs and the part is joined. At this time, the plate 33a, the first magneto-sensitive element 10a and the electrode 31a all become connected with each other. After that, the plate 33 is trimmed, and the joining of the first magneto-sensitive element 10a to the electrode is complete. In this way, on a single base, a great number of magneto-sensitive elements can be arranged successively and ultrasonic bonding can be carried out. Next, the base may be separated into rectangular shaped pieces as shown in Figure 6.

The electrode 31a material can be any material that can be ultrasonically bonded to the magneto-sensitive element, that is any material that is conductive. For example, it is desired that it be nickel, aluminum, gold, copper, silver, tin, zinc, platinum, magnesium, rhodium, or an alloy containing at least one of these elements. Moreover, it is better if an aluminum or aluminum alloy layer 311a is formed on the surface of the electrode 31a as shown in Figure 7. This layer 311a can be made by placing an aluminum or aluminum alloy plate on electrode 31a, and on top of that placing magneto-sensitive element 10a, and on top of that placing another aluminum or aluminum plate 33a, and then carrying out supersonic bonding. If the material between which the magneto-sensitive element 10a is held from the top and the bottom is aluminum or aluminum alloy, there can be complete mechanical joining and complete electrical connection. It is acceptable to coat the electrode 31a with aluminum or aluminum alloy and then carry out joining. Electrodes 31a and 32a also serve as the joint for wire bonding which connects the part to the lead pin of the molded sensor chip.

The reason for using ultrasonic bonding is that soldering, the most common method for electric components, is inapplicable to the ferromagnetic amorphous metal wire. Two reasons for this are crystallization and the formation of an oxidation film on the wire surface. The present inventor is the first to discover that when carrying out ultrasonic bonding, if aluminum or aluminum alloy is used, the mechanical joint becomes secure and the electrical connection becomes excellent. As the surface oxidation film of the ferromagnetic amorphous metal wire is exfoliated with ultrasonic vibration, it combines with the aluminum alloy that acts as a reducing element. It is thought that by this mechanism the mechanical joint and electrical connection become excellent. When an aluminum or aluminum alloy plate 33a is placed on top of the magneto-sensitive element 10a made of ferromagnetic amorphous metal wire, the direct transmission of the impact force of the bonding tool 90 during the connection period to the magneto-sensitive element 10a is prevented. Moreover, plate 33a acts as a shock absorber and prevents the generation of stress and strain in the magneto-sensitive element 10a during ultrasonic bonding.

Next, as seen in the sensor chip 100 in Figure 6, the periphery of the first magneto-sensitive element 10a is covered with a gel-like substance 35a (seen in Figures 6 and 10). The space between the first magneto-sensitive element 10a and the base 30a, as well as the space above the first magneto-sensitive element 10a, is filled (covered) with the gel-like substance. The reason for covering the first magneto-sensitive element 10a with this gel-like substance is to prevent stress from being applied to the first magneto-sensitive element 10a and to prevent stress from being generated inside the first magneto-sensitive element 10a. When the first magneto-sensitive element 10a is composed of ferromagnetic amorphous metal wire, the magnetic properties are easily influenced by strain. This stress is generated during the mold formation, as described later, by the shrinking during resin hardening. This stress is absorbed by the gel-like substance 35a and is not applied to the first magneto-sensitive element 10a. When done in this way, the detection precision can be increased. Silicone gel, silica gel, elastomer, gelatin, or similar materials can be used as the gel-like substance.

Next, the sensor chip 100, as shown in Figure 6, is inserted into the open space in the center of the bobbin 80a, around which the first detection coil 11a and the first negative feedback coil 12a are wrapped, as seen in Figure 10. Then the bobbin 80a and the base 10a are joined. Next, the bobbin 80a and its inherent sensor chip 100 are joined to a flat ceramic base 81 as shown in Figure 9. Similarly, the sensor chip is inserted into the open space in the center of the bobbin 80b, around which the first detection coil 11b and the first negative feedback coil 12b are wrapped. Then the bobbin 80b and the base 10b are joined and the bobbin 80b is joined to the ceramic base 81. At this time, the first magneto-sensitive elements 10a and 10b are arranged parallel to the first axial direction (x direction).

The first detection coil 11a and the first negative feedback coil 12a are wrapped around the bobbin together at the same time. That is to say, that the production becomes easier as the two wires can be wrapped in the same direction at the same time. Of course, the coils may be wrapped one by one in the same or in different directions. If the coils are wrapped opposite directions, the terminals should be switched. The number of coils and the direction are optional. This is also true for the first detection coil 11b and the first negative feedback coil 12b.

Similarly, the pair of second magneto-sensitive elements 40a and 40b shown in Figure 5 is formed into similar sensor chips as 100. The pair of bobbins 84a and 84b (Figure 10) wound with the pair of second detection coils 41a and 41b and the pair of second negative feedback coils 42a and 42b is formed. Then the bobbins 84a and 84b and their inherent sensor chips are fixed to the ceramic base 82. At this time, the pair of second magneto-sensitive elements 40a and 40b are arranged parallel to the second axial direction (y direction) which is at a right angle to the first axial direction.

On top of ceramic base 81, as shown in Figure 8, after the wiring film is vapor deposited, the pair of first magneto-sensitive elements 10a and 10b, the pair of first detection coils 11a and 11b and the pair of first negative feedback coils 12a and 12b are secured to their electric connections by wire bonding or soldering. Moreover, the electrical connection between each wiring film of the ceramic base 81 and each lead pin 93 is made by soldering or wire bonding. There are eight lead pins 93 in total consisting of two pins supplying current to the pair of first magneto-sensitive elements 10a and 10b, four pins outputting the various detection signals of the pair of fist detection coils 11a and 11b, one pin supplying current to the pair of first negative feedback coils 12a and 12b and one ground pin. Because the connection point of the pair of first magneto-sensitive elements 10a and 10b and one end of the series connection of the pair of first negative feedback coils 12a and 12b are connected to ground, the number of pins can be reduced. The detection in the second axial direction is done in the exact same way.

As shown in Figures 8 and 9, after assembly, the formation of a resin mold is carried out. Then the mold 95 as seen in Figure 9 is formed, the edges of the lead frame are cut, the lead pins 93 are bent, and the detection device with a mold IC shape as seen in Figure 9 is produced.

As written above, for the enforcement of the present invention, various other examples of changes to the design can be imagined. It is acceptable to have the first axial component detection device and the second axial component detection device arranged both on the same side and on different sides. Moreover, it is acceptable for the pair of magneto-sensitive elements to be arranged in parallel to each other or in a straight line. It is also acceptable to have a " + " shaped arrangement when arranged on both sides of the base, or a " T " shaped arrangement when arranged on a single side of the base. A detection device comprising a pair of magneto-sensitive elements has been mentioned, however a detection device can also be produced with a single magneto-sensitive element such as that shown in Figure 4, in the mold. It is also acceptable to use other types of packaging than the mold. It is also acceptable to mold only the sensor part made from the magneto-sensitive elements, the detection coils, and the negative feedback coils or to mold the entire detection device to make a mold IC, as shown in Figures 4 and 5 where the circuit is an IC chip and the sensor part and the IC chip are molded commonly. Similarly, if another type of packaging method is used, it is possible to (package) the entire detection device or individual IC elements.

A magnetic field detection device that detects two components of an external magnetic field. The device uses the magneto-impedance effect in ferromagnetic amorphous wire. A detection coil wrapped around the amorphous wire detects the magnetic flux change of the amorphous wire, which is proportional to the external magnetic field. The sensitivity of the device is increased due to circuitry that extracts the initial output pulse. It is also increased with the use of negative feedback and with the comparison of differential outputs. The two sets of detection elements are placed orthogonally for greatest sensitivity. Resin molding is employed for easy handling. This detection device can be used as part of a compass.

A magnetic field detection device that detects two components of an external magnetic field. The device uses the magneto-impedance effect in ferromagnetic amorphous wire. A detection coil wrapped around the amorphous wire detects the magnetic flux change of the amorphous wire, which is proportional to the external magnetic field. The sensitivity of the device is increased due to circuitry that extracts the initial output pulse. It is also increased with the use of negative feedback and with the comparison of differential outputs. The two sets of detection elements are placed orthogonally for greatest sensitivity. Resin molding is employed for easy handling. This detection device can be used as part of a compass.

## Claims

**1.** A magnetic field detection device for detection of an external magnetic field comprising:

a magneto-sensitive element, called the first magneto-sensitive element, which is excited in its circuital direction by either a pulsed or high frequency current to detect the first axial component of the external magnetic field;
a second magneto-sensitive element, called the second magneto-sensitive element, intended to detect at least one other axial component, arranged on a plane that possesses a common normal to the plane containing the first magneto-sensitive element, which is magnetically excited in its circuital direction by either a pulsed current or a HF current to detect an axial component of the external magnetic field, hereafter called the second axial component;
A first detection coil wrapped around the first magneto-sensitive element in the circuital direction and used to detect the magnetic flux fluctuation in the first axial direction;
A second detection coil is wrapped around the second magneto-sensitive element in the circuital direction and can detect the magnetic flux fluctuation in the second axial direction.

**2.** The magnetic field detection device as defined in claim 1, wherein said device comprises:

a switch, called the first switch, which can extract the initial pulse of the first detection coil output;
a switch, hereafter called the second switch, which can extract the initial pulse of the second detection coil output.

**3.** The magnetic field detection device as defined in claim 2, wherein said device comprises:

a signal processing circuit, called the first signal processing circuit, which outputs a signal formed either by the peak of the single or repeated signal passed through the first switch;
a signal processing circuit, called the second signal processing circuit, which outputs the signal formed either by the peak of the signal passed through the second switch or by the repeated output signal.

**4.** The magnetic field detection device as defined in claim 3, wherein said device comprises:

a negative feedback coil, called the first negative feedback coil, wrapped around the first magneto-sensitive element in the circuital direction, which can generate a magnetic field which cancels the first axial component of the external magnetic field in response to the output signal of the first signal processing circuit;
a negative feedback coil, called the second negative feedback coil, wrapped around the second magneto-sensitive element which can generate a magnetic field which cancels the second axial component of the external magnetic field in response to the output signal of the second signal processing circuit;
a negative feedback circuit, called the first negative feedback circuit, which controls the flow of electricity to the first negative feedback coil in order to make the output signal of the first signal processing circuit equal to zero;
a negative feedback circuit, called the second negative feedback circuit, which controls the flow of electricity to the second negative feedback coil in order to make the output signal of the second signal processing circuit equal to zero.

**5.** The magnetic field detection devices as defined in claim 1, wherein said device comprises:

a pulse generator to supply the aforementioned pulsed current.

**6.** The magnetic field detection devices as defined in claim 4, wherein said device comprises:
a pulse generator to supply the aforementioned pulsed current.

**7.** The magnetic field detection device as defined in claim 5, wherein said pulse generator comprises:
a square wave generating circuit and a differentiation circuit which differentiates the output of the square wave generating circuit, expressing the differential signal as a pulsed current.

**8.** The magnetic field detection device as defined in claim 1, wherein said device comprises:

a pair of first magneto-sensitive elements both penetrated by the first axial component of the external magnetic field, through which a pulsed current is passed;
a pair of first detection coils, one wound around each of the first magneto-sensitive elements in the circuital direction;
a pair of second magneto-sensitive elements both penetrated by the second axial component of the external magnetic field, through which a pulsed current is passed;
a pair of second detection coils, one wound around each of the second magneto-sensitive elements in the circuital direction.

**9.** The magnetic field detection device as defined in claim 8, wherein said device comprises:

a pair of first switches which can extract the initial pulse of the respective outputs of the pair of first detection coils;
a pair of second switches which can extract the initial pulse of the respective outputs of the pair of second detection coils;

**10.** The magnetic field detection device as defined in claim 9, wherein said device comprises:

a pair of first signal processing circuits which output signals formed either by the peak of the single or repeated signals passed through the pair of first switches;
a pair of second signal processing circuits which output signals formed either by the peak of the single or repeated signals passed through the pair of second switches;

**11.** The magnetic field detection device as defined in claim 10, wherein said device comprises:

a pair of first negative feedback coils that generate a magnetic field in the opposite direction as the first axial component that cancels the first axial component of the external magnetic field in response to the output signals of the pair of fist signal processing circuits;
a pair of second negative feedback coils that generate a magnetic field in the opposite direction as the second axial component that cancels the second axial component of the external magnetic field in response to the output signals of the pair of second signal processing circuits;
a first negative feedback circuit that supplies a current to the pair of first negative feedback coils, which makes the difference between the opposite-polarity outputs of the pair of first signal processing circuits equal to zero;
a second negative feedback circuit that supplies a current to the pair of second negative feedback coils, which makes the difference between the opposite-polarity outputs of the pair of second signal processing circuits equal to zero.

**12.** The magnetic field detection devices as defined in claim 8, wherein said devices comprise:
either two independent oscillators or a single common oscillator to provide a pulsed current to the pair of first magneto-sensitive elements and to the pair of second magneto-sensitive elements.

**13.** The magnetic field detection devices as defined in claim 11, wherein said devices comprise:
either two independent oscillators or a single common oscillator to provide a pulsed current to the pair of first magneto-sensitive elements and to the pair of second magneto-sensitive elements.

**14.** The magnetic field detection device as defined in claim 12, wherein said oscillator comprises:
a square wave oscillating circuit and a differentiating circuit which creates a pulsed current from the differentiated output of the square wave oscillating circuit.

**15.** The magnetic field detection devices as defined in claim 1. wherein one end of the first and the second magneto-sensitive elements, as well as one end of the negative feedback coil, is connected to ground.

**16.** The magnetic field detection devices as defined in claim 7, wherein one end of the first and the second magneto-sensitive elements, as well as one end of the negative feedback coil, is connected to ground.

**17.** The magnetic field detection devices as defined in claim 8, wherein the connection point of the pair of first magneto-sensitive elements, the connection point of the pair of second magneto-sensitive elements, as well as one end of the series connection of the negative feedback coils are connected to ground.

**18.** The magnetic field detection devices as defined in claim 14, wherein the connection point of the pair of first magneto-sensitive elements, the connection point of the pair of second magneto-sensitive elements, as well as one end of the series connection of the negative feedback coils are connected to ground.

**19.** The magnetic field detection devices as defined in claim 1, wherein the first magneto-sensitive elements, as well as the second magneto-sensitive elements, possess magnetic anisotropy in the circuital direction.

**20.** The magnetic field detection devices as defined in claim 8, wherein the first magneto-sensitive elements, as well as the second magneto-sensitive elements, possess magnetic anisotropy in the circuital direction.

**21.** The magnetic field detection devices as defined in claim 11, wherein the first magneto-sensitive elements, as well as the second magneto-sensitive elements, possess magnetic anisotropy in the circuital direction.

**22.** The magnetic field detection devices as defined in claim 19, wherein the first and second magneto-sensitive elements are elements that have a skin effect with respect to the pulsed current.

**23.** The magnetic field detection devices as defined in claim 19, wherein the first and second magneto-sensitive elements are made of ferromagnetic amorphous metal.

**24.** The magnetic field detection devices as defined in claim 21, wherein the first and second magneto-sensitive elements are made of ferromagnetic amorphous metal.

**25.** The magnetic field detection devices as defined in claim 19, wherein the first and second magneto-sensitive elements are ferromagnetic amorphous metal wire.

**26.** The magnetic field detection devices as defined in claim 21, wherein the first and second magneto-sensitive elements are ferromagnetic amorphous metal wire.

**27.** The magnetic field detection devices as defined in claim 1, wherein the first and second magneto-sensitive elements, the first and second detection coils and the first and second negative feedback coils are loaded on a base and united into a resin-mold package.

**28.** The magnetic field detection devices as defined in claim 26, wherein the first and second magneto-sensitive elements, the first and second detection coils and the first and second negative feedback coils are loaded on a base and united into a resin-mold package.

**29.** The magnetic field detection devices as defined in claim 1, wherein the electrode formed on the base supports both ends of the first and second magneto-sensitive elements and a gel-like substance surrounds the first and second magneto-sensitive elements and fills in the space between them.

**30.** The magnetic field detection devices as defined in claim 4, wherein the electrode formed on the base supports both ends of the first and second magneto-sensitive elements and a gel-like substance surrounds the first and second magneto-sensitive elements and fills in the space between them.

**31.** The magnetic field detection devices as defined in claim 8, wherein the electrode formed on the base supports both ends of the first and second magneto-sensitive elements and a gel-like substance surrounds the first and second magneto-sensitive elements and fills in the space between them.

**32.** The magnetic field detection devices as defined in claim 11. wherein the electrode formed on the base supports both ends of the first and second magneto-sensitive elements and a gel-like substance surrounds the first and second magneto-sensitive elements and fills in the space between them.

**33.** The magnetic field detection devices as defined in claim 1, wherein the first magneto-sensitive element is arranged on the surface of the base, and the second magneto-sensitive element is arranged on the back of the base.

**34.** The magnetic field detection devices as defined in claim 8, wherein the first magneto-sensitive element is arranged on the surface of the base, and the second magneto-sensitive element is arranged on the back of the base.

**35.** The magnetic field detection devices as defined in claim 1, wherein the electrodes supporting the flow of electricity are placed at both ends of the first and second magneto-sensitive elements, the elements are covered in aluminum or aluminum alloy, and the first and second magneto-sensitive elements and the electrodes are connected by way of ultrasonic bonding.

**36.** The magnetic field detection devices as defined in claim 4, wherein the electrodes supporting the flow of electricity are placed at both ends of the first and second magneto-sensitive elements, the elements are covered in aluminum or aluminum alloy, and the first and second magneto-sensitive elements and the electrodes are connected by way of ultrasonic bonding.

**37.** The magnetic field detection devices as defined in claim 8, wherein the electrodes supporting the flow of electricity are placed at both ends of the first and second magneto-sensitive elements, the elements are covered in aluminum or aluminum alloy, and the first and second magneto-sensitive elements and the electrodes are connected by way of ultrasonic bonding.

**38.** The magnetic field detection devices as defined in claim 11, wherein the electrodes supporting the flow of electricity are placed at both ends of the first and second magneto-sensitive elements, the elements are covered in aluminum or aluminum alloy, and the first and second magneto-sensitive elements and the electrodes are connected by way of ultrasonic bonding.

**39.** The magnetic field detection devices as defined in claim 35, wherein the electrodes are formed of nickel, aluminum, gold, copper, silver, tin. zinc, platinum, magnesium, rhodium, or an alloy containing at least one of these elements.

**40.** The magnetic field detection devices as defined in claim 38, wherein the electrodes are formed of nickel, aluminum, gold, copper, silver, tin, zinc, platinum, magnesium, rhodium, or an alloy containing at least one of these elements.

**41.** The magnetic field detection devices as defined in claim 39, wherein the electrodes possess a surface layer of aluminum or aluminum alloy.

**42.** The magnetic field detection devices as defined in claim 40, wherein the electrodes possess a surface layer of aluminum or aluminum alloy.

**43.** The magnetic field detection devices as defined in claim 1 wherein the magnetic field detection device is a direction detection device that can detect the direction of the external magnetic field. i.e., it can detect the first and second axial external magnetic field components.

**44.** The magnetic field detection devices as defined in claim 42 wherein the magnetic field detection device is a direction detection device that can detect the direction of the external magnetic field, i.e., it can detect the first and second axial external magnetic field components.

**45.** The magnetic field detection devices as defined in claim 43, wherein the first and second axes cross each other.

FIG. 1

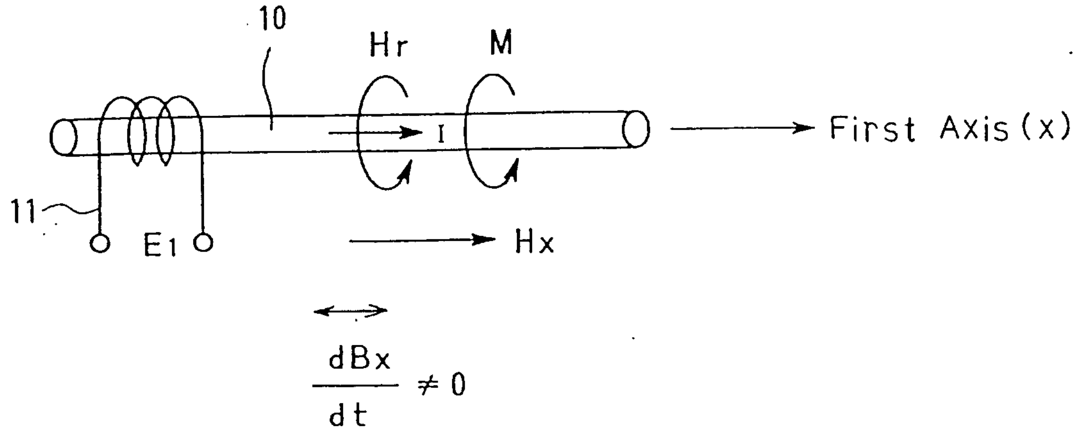
10
Hr
M
I
First Axis (x)
11
E1
Hx
dBx/dt ≠ 0

FIG. 2

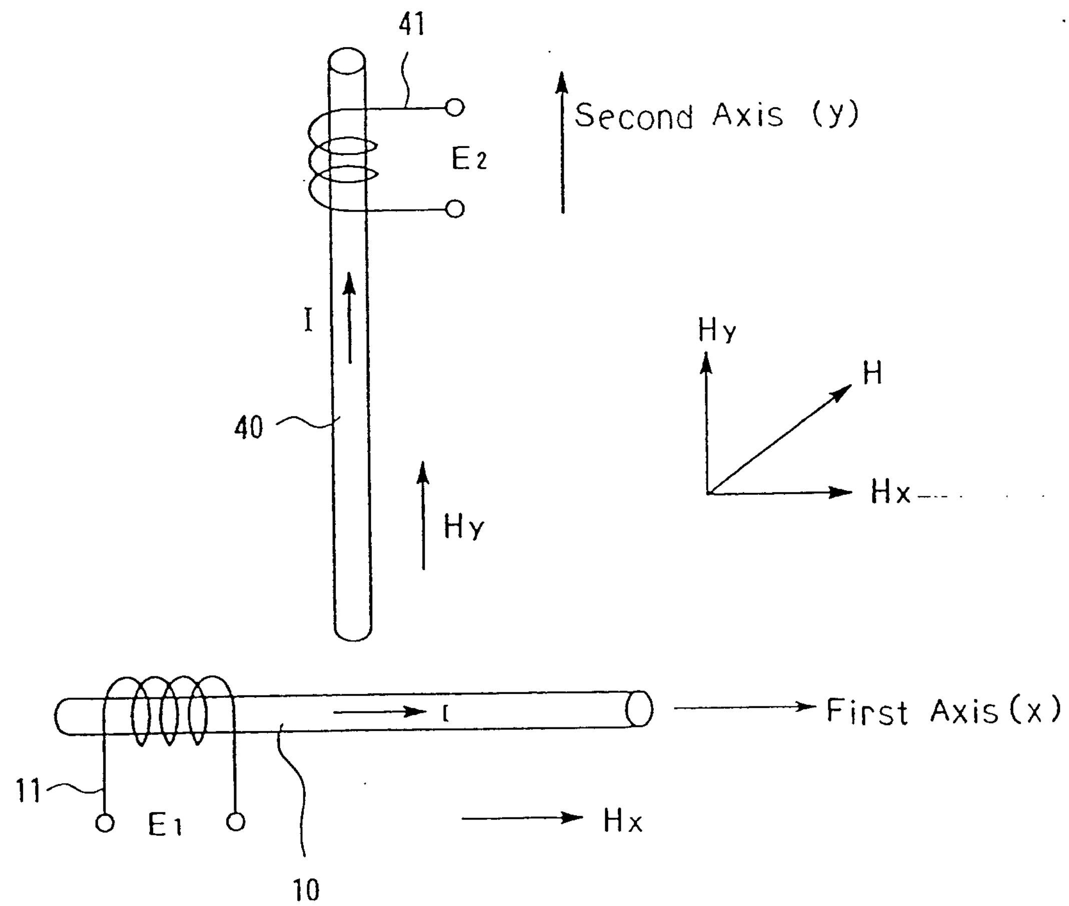
41
Second Axis (y)
E2
I
Hy
H
40
Hx
Hy
I
First Axis (x)
11
E1
Hx
10

FIG.3

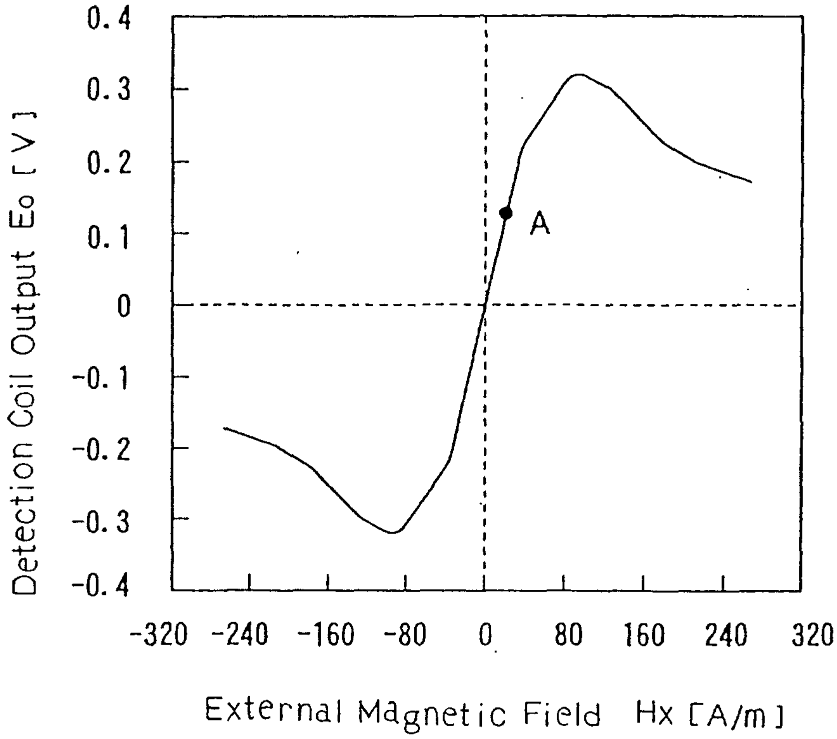
0.4
0.3
0.2
0.1
0
-0.1
-0.2
-0.3
-0.4
Detection Coil Output Eo [V]
A
-320 -240 -160 -80 0 80 160 240 320
External Magnetic Field Hx [A/m]

FIG. 4

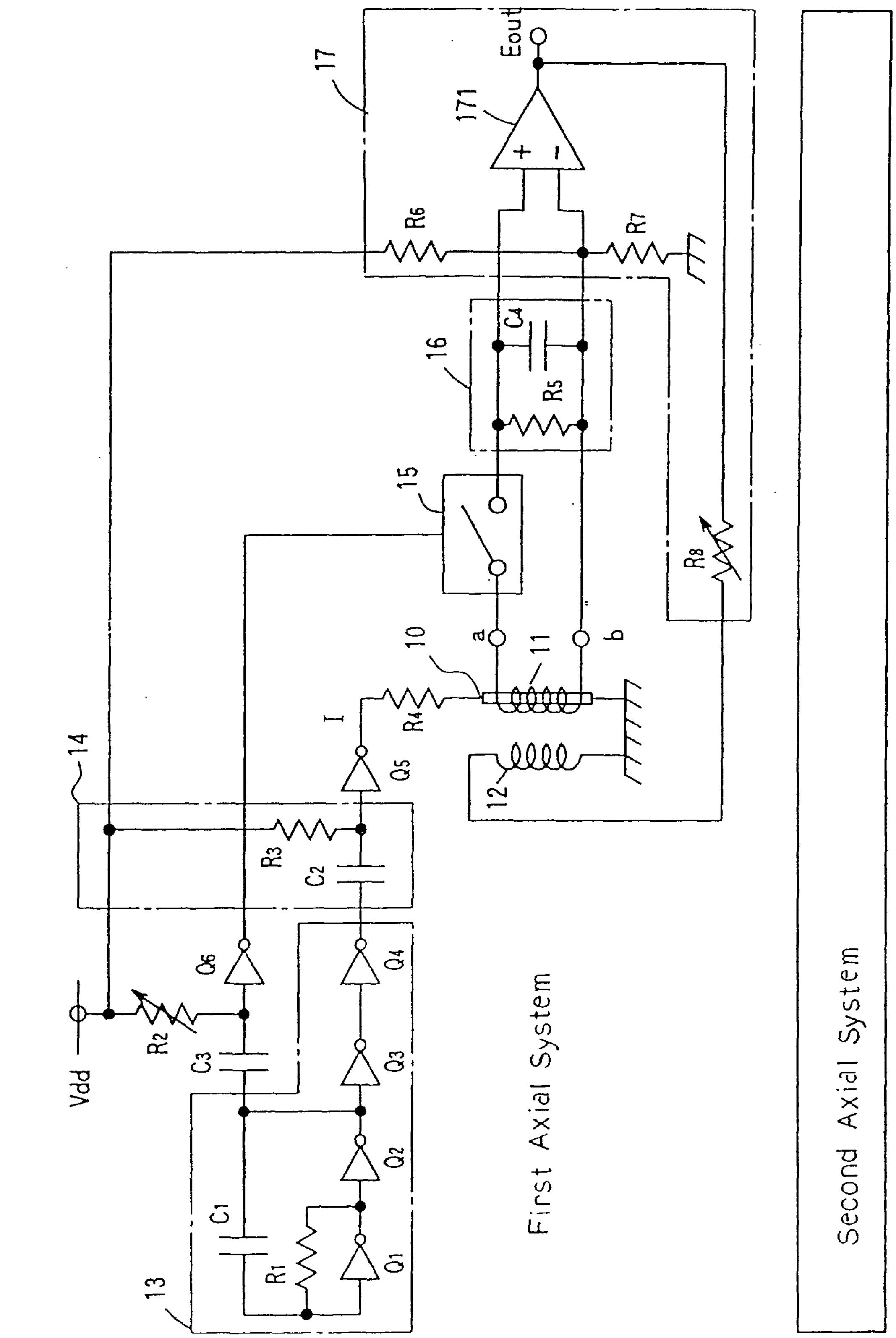
Vdd
Eout
First Axial System
Second Axial System
13
14
15
16
17
171
10
11
12
a
b
I
R1
R2
R3
R4
R5
R6
R7
R8
C1
C2
C3
C4
Q1
Q2
Q3
Q4
Q5
Q6

FIG.5

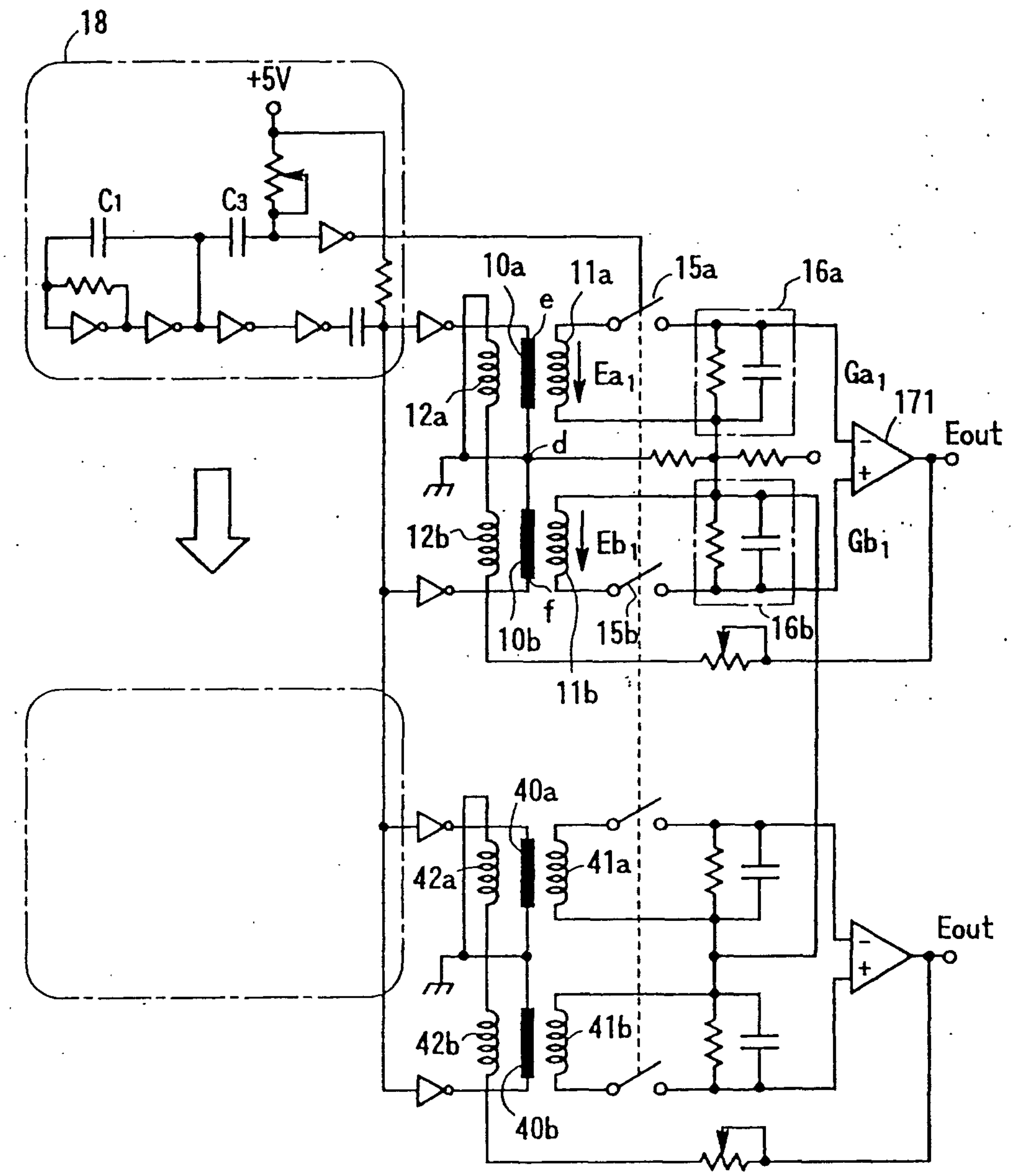
18
+5V
C1
C3
10a
11a
15a
16a
e
Ea1
Ga1
171
Eout
12a
d
12b
Eb1
Gb1
f
10b
15b
16b
11b
40a
41a
42a
Eout
42b
41b
40b

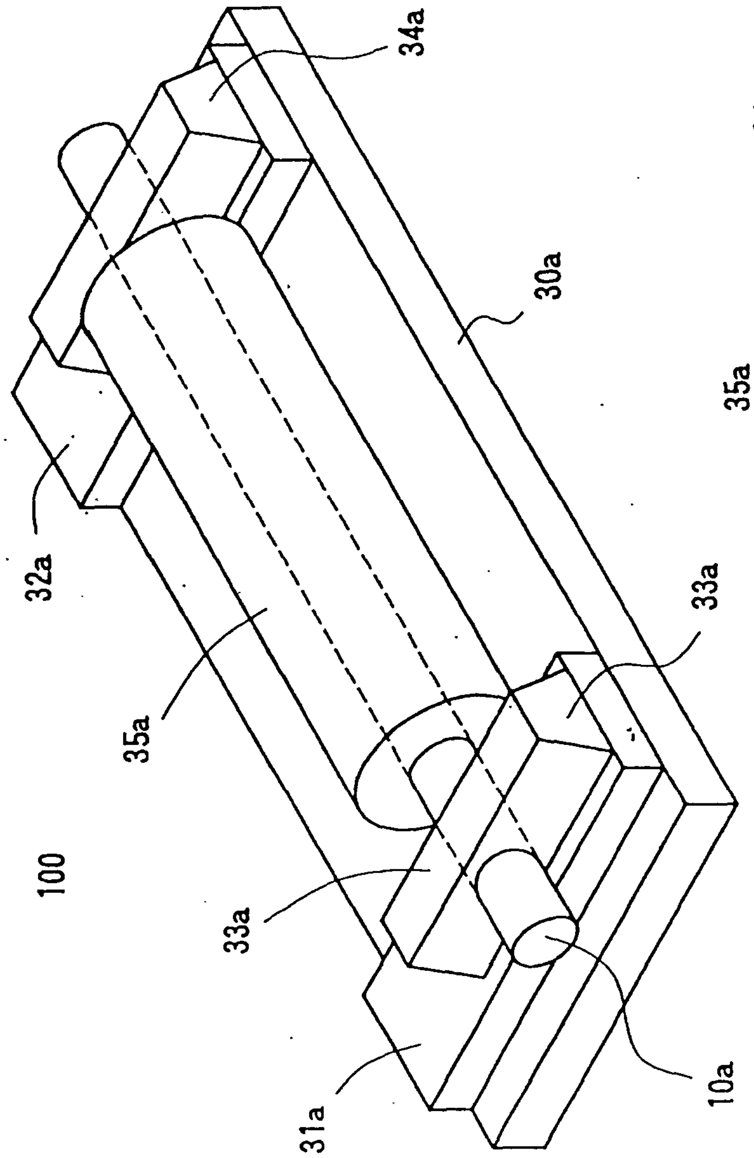


FIG. 6A

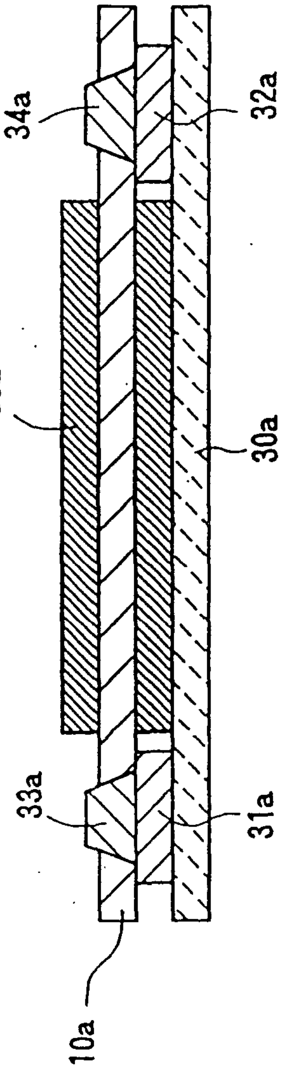


FIG. 6B

FIG.7

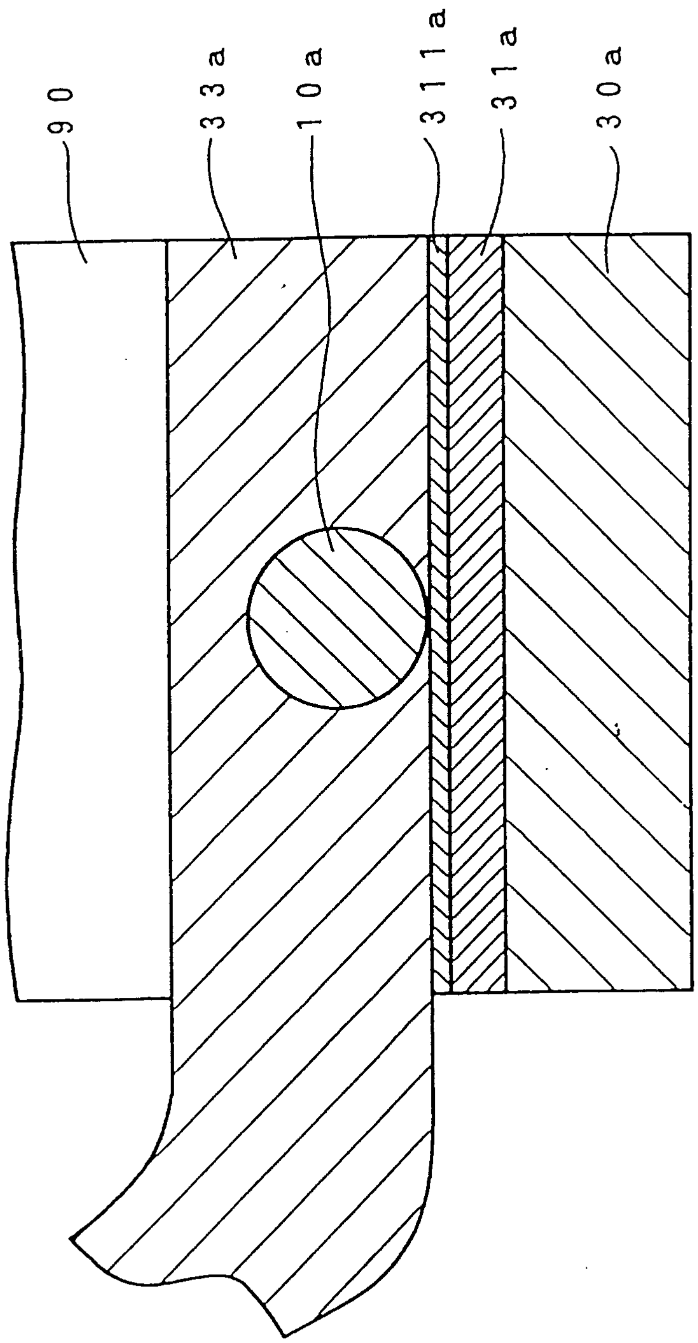

FIG. 8

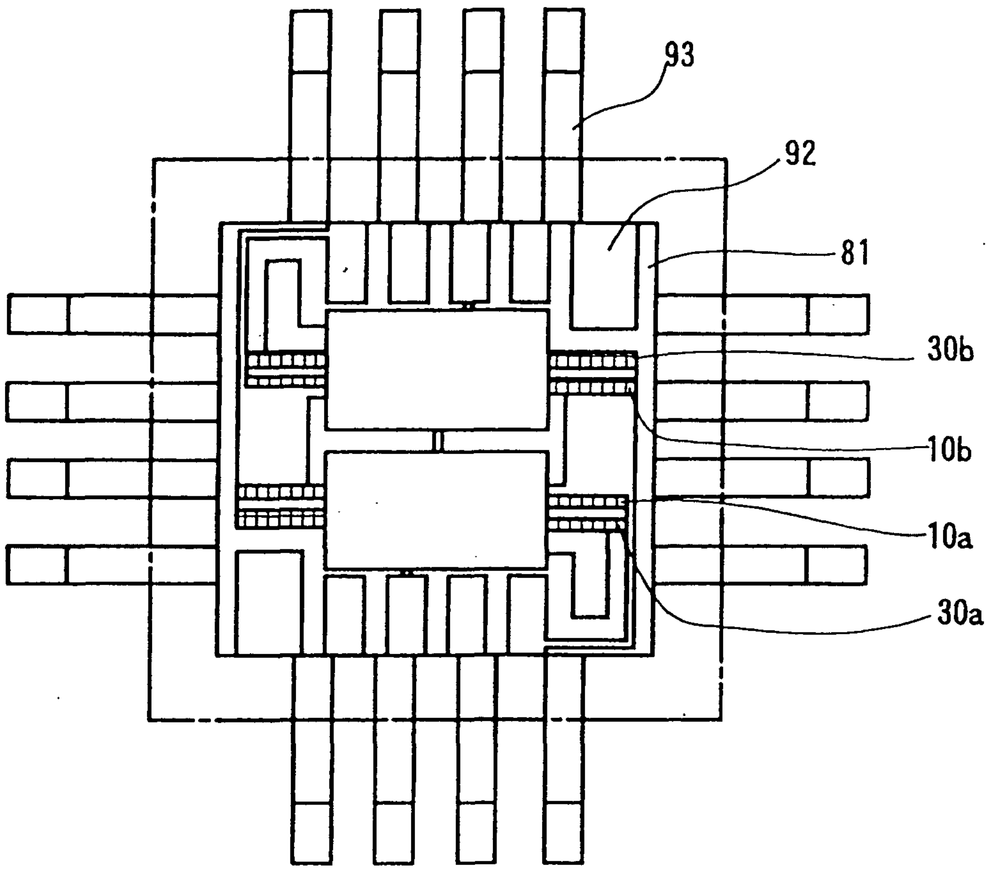

FIG.9

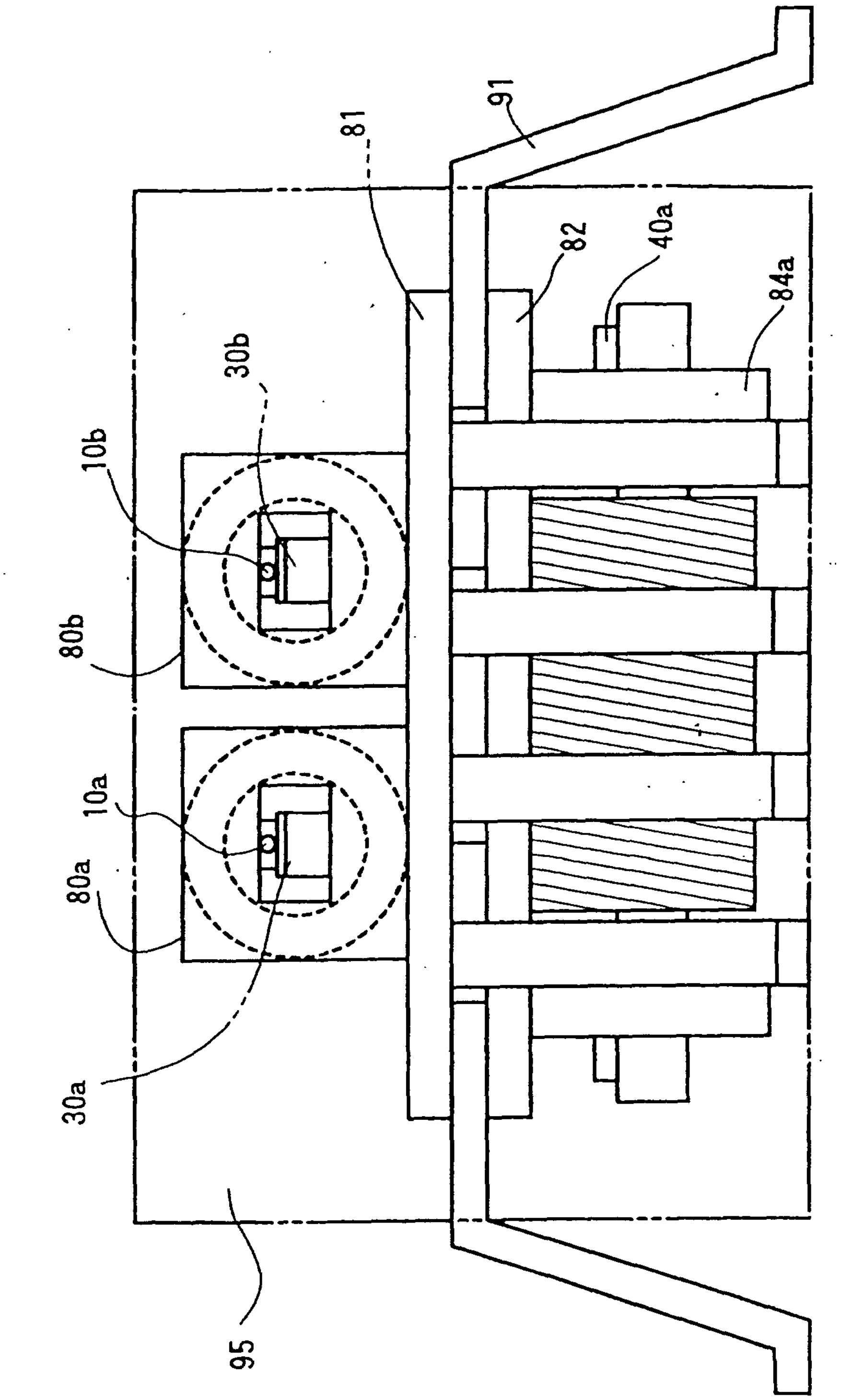

FIG.10

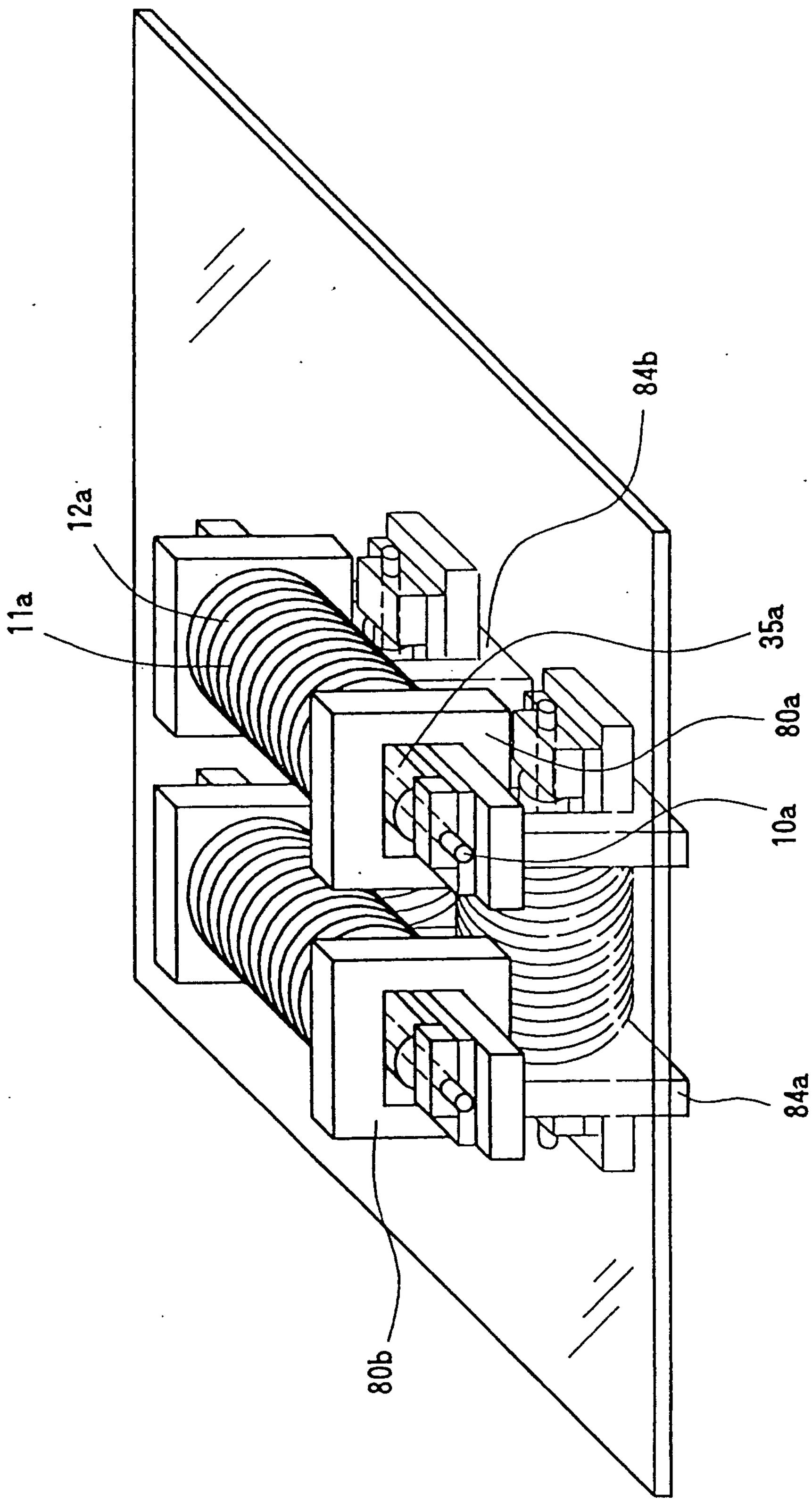

European Patent Office

# EUROPEAN SEARCH REPORT

Application Number
EP 01 10 0275

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X<br><br><br>Y | US 4 939 459 A (AKACHI YOSHIAKI ET AL) 3 July 1990 (1990-07-03)<br>* column 3, line 33 - column 5, line 20 *<br>* example 3 *<br>* figures 10 and 12 *<br>--- | 1-3,5,<br>43,45<br><br>4,6-14,<br>19-28,<br>35-42,44 | G01R33/02 |
| Y | KAWAJIRI N ET AL: "HIGHLY STABLE MI MICRO SENSOR USING C-MOS IC MULTIVIBRATOR WITH SYNCHRONOUS RECTIFICATION"<br>IEEE TRANSACTIONS ON MAGNETICS,IEEE INC. NEW YORK,US,<br>vol. 35, no. 5, PART 02,<br>September 1999 (1999-09), pages 3667-3669, XP000868033<br>ISSN: 0018-9464<br>* abstract *<br>* section II: "MI sensor circuit"; figures 1 and 5 *<br>--- | 4,6-14,<br>19-26,<br>28,<br>36-42,44 | |
| Y | EP 0 892 276 A (ALPS ELECTRIC CO LTD) 20 January 1999 (1999-01-20)<br>* column 7, line 10 - column 10, line 25; figures 3A-C,6 *<br>--- | 27,28,<br>35-42 | TECHNICAL FIELDS SEARCHED (Int.Cl.7)<br>G01R |
| A | MASUDA S: "MEASUREMENTS OF MAGNETIZATION DYNAMICS AND MAGNETOIMPEDANCE IN FECOSIB AND FESIB AMORPHOUS WIRES"<br>JOURNAL OF APPLIED PHYSICS,US,AMERICAN INSTITUTE OF PHYSICS. NEW YORK,<br>vol. 79, no. 8, PART 02B,<br>15 April 1996 (1996-04-15), pages 6542-6544, XP000695095<br>ISSN: 0021-8979<br>* abstract; figure 1 *<br>----- | 1 | |

The present search report has been drawn up for all claims

| Place of search | Date of completion of the search | Examiner |
|---|---|---|
| MUNICH | 11 July 2001 | Jakob, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 01 10 0275

This annex lists the patent family members relating to the patent documents cited in the above-mentioned European search report.
The members are as contained in the European Patent Office EDP file on
The European Patent Office is in no way liable for these particulars which are merely given for the purpose of information.

11-07-2001

| Patent document cited in search report | Publication date | Patent family member(s) | Publication date |
|---|---|---|---|
| US 4939459 A | 03-07-1990 | JP 2062986 A | 02-03-1990 |
| | | JP 2582132 B | 19-02-1997 |
| | | JP 2062987 A | 02-03-1990 |
| | | JP 2582133 B | 19-02-1997 |
| | | JP 1163686 A | 27-06-1989 |
| | | JP 2617498 B | 04-06-1997 |
| | | DE 3843087 A | 29-06-1989 |
| EP 0892276 A | 20-01-1999 | JP 11030657 A | 02-02-1999 |
| | | JP 11030656 A | 02-02-1999 |
| | | US 6121770 A | 19-09-2000 |

EPO FORM P0459

For more details about this annex : see Official Journal of the European Patent Office, No. 12/82